# EUROPEAN PATENT APPLICATION

(11) **EP 3 726 294 A1**
(43) Date of publication of application: **21.10.2020**
(21) Application number: 18887484.6
(22) Date of filing: 20.09.2018
(51) Int. Cl.: G03F 7/20

(54) **NEGATIVE-REFRACTION IMAGING PHOTOLITHOGRAPHY METHOD AND APPARATUS**

(30) Priority: 11.12.2017 CN 201711323769
(71) Applicant: The Institute of Optics and Electronics The Chinese Academy of Sciences, Chengdu, Sichuan 610209 (CN)
(72) Inventor: LUO, Xiangang, Chengdu, Sichuan Sichuan 610209 (CN); WANG, Yanqin, Chengdu, Sichuan Sichuan 610209 (CN); WANG, Changtao, Chengdu, Sichuan Sichuan 610209 (CN); LIU, Ling, Chengdu, Sichuan Sichuan 610209 (CN); KONG, Weijie, Chengdu, Sichuan Sichuan 610209 (CN); GAO, Ping, Chengdu, Sichuan Sichuan 610209 (CN)
(74) Representative: Grünecker Patent- und Rechtsanwälte PartG mbB
(86) International application number: PCT/CN2018/106685
(87) International publication number: WO 2019/114359

(57) **Abstract**

The embodiments of the present disclosure propose a negative refraction imaging lithographic method and equipment. The lithographic method includes: coating photoresist on a device substrate; fabricating a negative refraction structure, wherein the negative refraction structure exhibits a negative refraction index for a wavelength of light emitted by an exposure source; pressing a lithographic plate mask to be close to the negative refraction structure; disposing the lithographic plate mask and the negative refraction structure above the device substrate at a projection distance equal to a projection gap away from the device substrate; and light emitted by the exposure source passes through the lithographic plate mask, the negative refraction structure, the projection gap and is sequentially projected onto the photoresist for exposure. Compared with conventional projection lithography, dozens of lenses with a nano-precision in surface shape and position are not required in the negative refraction imaging lithographic method and device, and costs may be drastically reduced. At the same time, the method has the characteristics of non-optical axis imaging, the entire negative refraction imaging structure has spatial translational symmetry, and thereby lithography with a large field of view may be realized.

## Description

### CROSS-REFERENCE TO RELATED APPLICATION(S)

This application claims priority to the Chinese Patent Application No. 201711323769.7, filed on December 11, 2017, entitled "NEGATIVE REFRACTION IMAGING LITHOGRAPHIC METHOD AND EUQIPMENT", which is incorporated herein by reference in its entirety.

### TECHNICAL FIELD

The present disclosure relates to the field of lithography, and more particularly, to a nano-imaging lithographic method and equipment which achieves a large area and a low cost, and in particular, to a negative refraction imaging lithographic method and equipment.

### BACKGROUND

Optical lithography is one of the important technical approaches for micro-nano manufacturing, and is widely applied in fields such as integrated circuits, optoelectronic devices, new material manufacturing, biomedicine etc. A resolution of a projection lithographic equipment depends on a numerical aperture NA of a projection objective and a wavelength wl of a light source. In order to realize high-resolution lithography, a numerical aperture of a projection objective of a conventional lithographic equipment is getting higher and higher. Currently, NA has exceeded 1, and may further achieve 1.4 if an immersion objective is used. However, a projection objective having a high numerical aperture involves twenty or thirty lenses, and shape accuracy and positioning accuracy of each lens need to be controlled on an order of nanometers. Therefore, the processing and detection technology of the entire projection objective is very complicated, which results in an increasing price of conventional high-resolution projection lithographic equipment (for example, a stepper and a scanner of photo lithography), with a single equipment costing tens of millions to hundreds of millions of dollars. Also due to technical complexity and cost issues, the conventional projection lithography may currently achieve a small field of view, and commercial lithographic machines generally have a fixed field of view which is 26mm^{∗}33mm. The cost may further be increased if stitching processing is used, which makes it difficult to meet requirements for processing of nano-devices such as integrated circuits, optoelectronics etc. with a larger area. In addition to the projection imaging lithography, proximity contact lithographic devices are also widely applied in scientific research and industrial fields, but confront with problems such as a low resolution (about 1 micron), contact friction between a mask pattern and a hard substrate such as a silicon wafer, easiness to damage patterns, a limited service life etc.

### SUMMARY

To this end, the present disclosure proposes a lithographic method and equipment based on negative refraction imaging.

The negative refraction imaging projection lithographic method and equipment according to the embodiments of the present disclosure achieve an imaging lens effect with a high numerical aperture and a nano-scale resolution using a multilayer structured film material, and may project and image a pattern of a mask onto photoresist which is at a distance of more than several hundred nanometers away, so as to achieve exposure and development of the photoresist.

According to an aspect of the present disclosure, there is proposed a negative refraction imaging lithographic method, comprising: coating photoresist on a device substrate; fabricating a negative refraction structure, wherein the negative refraction structure exhibits a negative refraction index for a wavelength of light emitted by an exposure source; pressing the lithographic plate mask to be close to the negative refraction structure; disposing the lithographic plate mask and the negative refraction structure above the device substrate at a projection distance equal to a projection gap away from the device substrate; and emitting, by the exposure source, light, and sequentially projecting the light onto the photoresist for exposure through the lithographic plate mask, the negative refraction structure, and the projection gap.

According to another aspect of the present disclosure, there is further proposed a negative refraction imaging lithographic equipment, comprising: an exposure source; a photoresist coating apparatus configured to coat photoresist on a device substrate; a negative refraction structure, wherein the negative refraction structure exhibits a negative refraction index for a wavelength of light emitted by the exposure source; and a first transmission apparatus, configured to fit a lithographic plate mask to the negative refraction structure, and dispose the lithographic plate mask and the negative refraction structure above the device substrate at a projection distance equal to a projection gap away from the device substrate, wherein light emitted by the exposure source passes through the lithographic plate mask, the negative refraction structure, and the projection gap and is sequentially projected onto the photoresist for exposure.

Compared with conventional projection lithographic lens, dozens of lenses with a nano-precision in surface shape and position are not required in the negative refraction imaging lithographic method and equipment according to the embodiments of the present disclosure, which may be performed by integrated processing methods such as coating and electron beams etc., and thereby lens development costs may be drastically reduced. At the same time, the method has the characteristics of non-optical axis imaging, and the entire negative refraction imaging structure has spatial translational symmetry. In consideration of surface shape processing accuracy and an -size of planar elements at present, lithography with an imaging size of 100mm² or more of a field of view may be realized. Due to physical isolation between the substrate and the mask, this method may implement operations such as high-precision alignment, positioning, and overlay processing of multilayer nano-structures etc. Based on the negative-refraction imaging lithographic structure, the present disclosure may realize high-resolution grayscale lithography for processing of a multi-step or continuous surface shape.

### BRIEF DESCRIPTION OF THE DRAWINGS

Fig. 1 illustrates a flowchart of a negative refraction imaging lithographic method according to an embodiment of the present disclosure.
Fig. 2 illustrates a schematic structural diagram of a negative refraction imaging lithographic equipment according to an embodiment of the present disclosure.
Fig. 3 illustrates a schematic diagram of a negative refraction imaging structure.
Fig. 4 illustrates a specific structural diagram of a negative refraction imaging lithographic method.
Fig. 5 illustrates a schematic diagram of a curved negative refraction imaging structure.
Fig. 6 illustrates a specific structural diagram of the negative refraction imaging lithographic equipment 200 shown in Fig. 2.
Fig. 7 illustrates a schematic diagram of grayscale lithography.
Fig. 8 illustrates a schematic diagram of two-dimensional pattern imaging lithography implemented by using a negative refraction imaging lithographic method and equipment according to an embodiment of the present disclosure.

### Reference signs

- 1: Illumination light beam
- 2: Lithographic plate mask
- 3: Negative refraction structure
- 4: Material with a positive dielectric constant
- 5: Material with a negative dielectric constant
- 6: Transmitted light wave
- 7: Unexposed photoresist
- 8: Imaging device substrate
- 9: Exposed photoresist
- 10: Imaging lithographic lens
- 11: Pattern input layer
- 12: Imaging output layer
- 13: Protective layer
- 14: Protective pane
- 15: Exposure source
- 16: Substrate leveling and gap control system
- 17: Working distance detection system
- 18: Vibration isolation platform
- 19: Stage
- 20: Imaging substrate
- 21: Alignment and positioning system
- 22: Clean box or vacuum box
- 23: Grayscale mask
- 24: Imaging field with nonuniform intensity
- 25: Mask with a vertical part of a two-dimensional pattern
- 26: Mask with a horizontal part of a two-dimensional pattern
- 27: Two-dimensional pattern

### DETAILED DESCRIPTION

Reference will now be made in detail to the embodiments of the present disclosure, examples of which are illustrated in the accompanying drawings, wherein the same numerals in the accompanying drawings all represent the same elements. Hereinafter, the embodiments of the present disclosure will be described in detail with reference to the accompanying drawings.

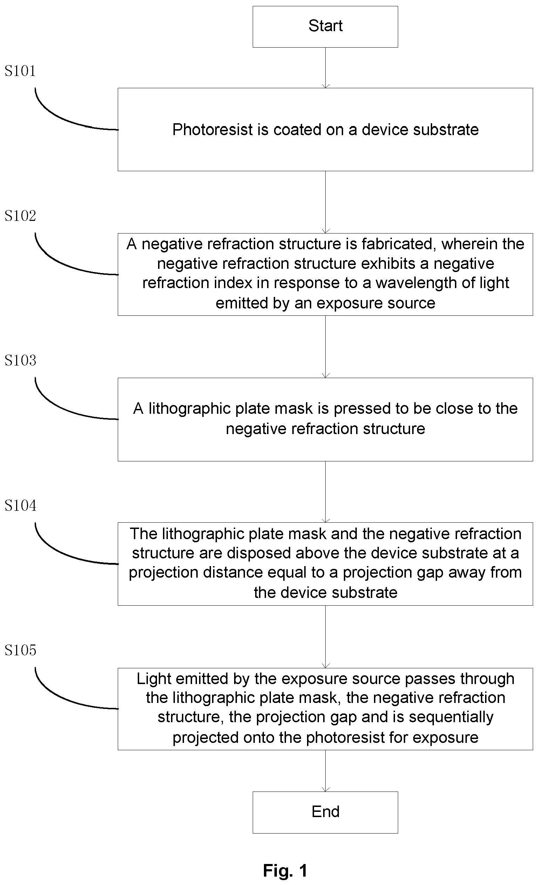

Fig. 1 illustrates a flowchart of a negative refraction imaging lithographic method according to an embodiment of the present disclosure. As shown in Fig. 1, the negative refraction index imaging lithographic method comprises: coating photoresist on a device substrate (S101); fabricating a negative refraction structure, wherein the negative refraction structure exhibits a negative refraction index for a wavelength of light emitted by an exposure source (S102); pressing a lithographic plate mask to be close to the negative refraction structure (S103); disposing the lithographic plate mask and the negative refraction structure above the device substrate at a projection distance equal to a projection gap away from the device substrate (S104); and light emitted by the exposure source passes through the lithographic plate mask, the negative refraction structure, the projection gap and is sequentially projected onto the photoresist for exposure (S105).

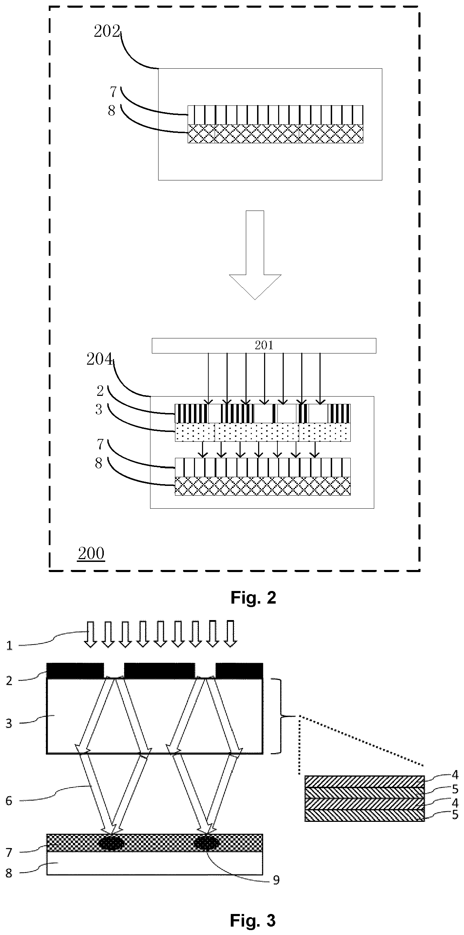

Fig. 2 illustrates a schematic structural diagram of a negative refraction imaging lithographic equipment according to an embodiment of the present disclosure. As shown in Fig. 2, the negative refraction imaging lithographic equipment (200) comprises: an exposure source (201); a photoresist coating apparatus (202) configured to coat photoresist (7) on a device substrate (8); a negative refraction structure (3), wherein the negative refraction structure (3) exhibits a negative refraction index for a wavelength of light emitted by the exposure source; a first transmission apparatus (204) configured to attach a lithographic plate mask (2) to the negative refraction structure, and dispose the lithographic plate mask (2) and the negative refraction structure (3) above the device substrate (8) at a projection distance equal to a projection gap away from the device substrate (3), wherein light emitted by the exposure source (1) passes through the lithographic plate mask (2), the negative refraction structure (3), and the projection gap and is sequentially projected onto the photoresist (7) for exposure.

Fig. 3 illustrates a schematic structural diagram of a negative refraction imaging structure. As shown in Fig. 3, an illumination light beam 1 is transmitted in the negative refraction structure 3 through the lithographic plate mask 2, and is finally focused and imaged on the photoresist 7 on the imaging substrate 8. As shown in an illustration on the right side of Fig. 3, the negative refraction imaging structure may be formed by alternately stacking a material 4 with a positive permittivity and a material 5 with a negative permittivity. Constraints of the negative refraction index s

The negative refraction structure has a negative effective refraction index, and has negative refraction optical behavior characteristics, comprising a multilayered negative refraction imaging lithographic structure, a hole-array multilayered negative refraction imaging lithographic structure, a composite negative refraction imaging lithographic structure, and a three-dimensional negative refraction structure. After the negative refraction index structure is described as an anisotropic material, a real part of a lateral component of a permittivity of the negative refraction index structure has an opposite sign to that of - a longitudinal component of the permittivity, wherein for a composite structure composed of metal and a dielectric, an effective permittivity of the composite structure has a lateral component being *ε_{∥}*=*f*·*ε*_{d}+(1-*f*)·*ε*ₘ and a longitudinal component being *ε*_{⊥}=*ε*_{d}·*ε*ₘ/[*f*·*ε*ₘ+(1-*f*)·*ε*_{d}], wherein *ε_{∥}·ε*_{⊥}<0 so that the negative refraction index structure exhibits negative refraction characteristics, where *ε*_{d} and *ε*ₘ are permittivities of the dielectric material and the metal material in the composite structure respectively, and *f* is a volume filling ratio of the metal.

A negative refraction structure of the multilayer film negative refraction imaging lithographic structure is formed by alternately stacking two or more material film layers having different dielectric constants, and a thickness of the material film layers satisfies an effective condition of negative refraction imaging. In order to realize a negative refraction effect, a permittivity of at least one kind of material needs to have a negative real part, and an imaginary part of permittivity determining loss characteristics needs to meet requirements of energy loss efficiency. The material of which a permittivity has a negative real part comprises, but not limited to, gold, silver, and aluminum. A two-dimensional hole array structure is introduced into the material of which a permittivity has a negative real part to modulate an effective permittivity and loss characteristics to realize negative refraction imaging, so as to form the hole-array multilayered negative refraction imaging lithographic structure. The multilayer film and the hole array layer structure are designed in combination to obtain a composite negative refraction imaging lithographic structure with a negative refraction index, in order to obtain a multilayered materials with suitable permittivity and loss coefficient which are difficult to be obtained in deep ultraviolet, near infrared, infrared etc. frequency ranges. The three-dimensional negative refraction structure is a three-dimensional metamaterial structure with a negative refraction index. The negative refraction imaging lithographic structure in a form of three-dimensional complex structure may realize negative refraction imaging which is independent of Transverse Electric (TE) and Transverse Magnetic (TM) polarization states and has no polarization aberration, for example, a three-dimensional metamaterial structural unit having a negative effective refraction index. By taking the unit as a basic structure, an imaging structure which could realize a fixed negative refraction index distribution and an imaging structure which could realize a variable negative refraction index distribution may be designed. Since the three imaging lithographic structures do not have isotropic negative refraction imaging performance, they may have different imaging effects - in different polarization states. In order to prevent light fields in different polarization states generated by complex two-dimensional patterns to affect imaging performance, a pattern of a single lithographic plate mask thereof is mostly a pattern of lines arranged in the same direction. The illumination light of which the electric field is polarized perpendicularly to the direction of the lines is selected, especially for a pattern with a small critical dimension. High-resolution two-dimensional complex patterns may be achieved by two or more lithography processes with different masks in different directions of patterns. Pattern optimization methods such as proximity effect correction, phase shift mask etc. may be used to improve the fidelity of negative refraction imaging.

By selecting the film material and thickness, or even filling liquid between the negative refraction imaging structure and the substrate of the lithographic device, an effect numerical aperture of the negative refraction imaging structure may be increased, thereby improving the imaging lithographic resolution.

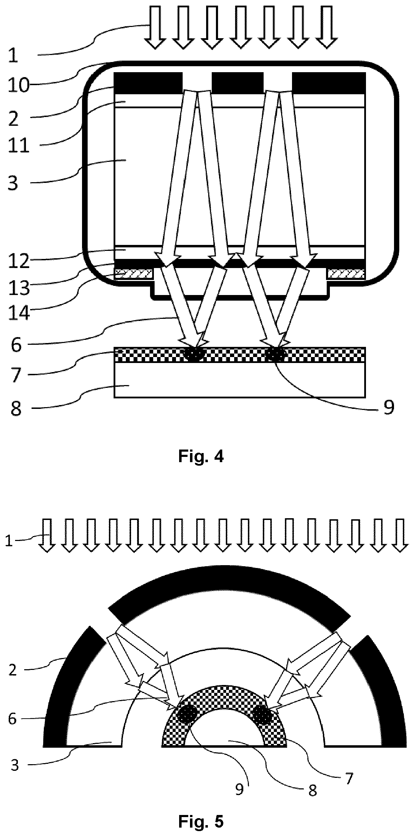

Fig. 4 illustrates a specific structural diagram of a negative refraction imaging lithographic method. As shown in Fig. 4, the negative refraction imaging lens 10 is composed of components such as a mask 2, pattern input layers 11, a negative refraction structure 3, imaging output layers 12, a protective layer 13, a protective pane 14 etc.

Specifically, the negative refraction structure further comprises pattern input layers on opposite sides thereof, and the pattern input layers planarize a pattern layer of the mask. A composition material of the pattern input layers is a transparent material having a high refraction index and a low loss, and a thickness of the pattern input layers is optimized to be matched with parameters of the negative refraction structure. The pattern input layers may be used to reduce reflection and increase efficiency of coupling a light field carrying information on a pattern of the mask to the negative refraction imaging structure. The pattern input layers may be used to reduce the adverse effect on performance of the imaged pattern by adjusting transverse electric TE wave components of the pattern light field passing through the mask.

The negative refraction structure further comprises imaging output layers on opposite sides thereof, and the imaging output layers are configured to reduce a difference between an effective refraction index of the negative refraction structure and an effective refraction index of an outer space where the projection gap is located. The imaging output layers are used to improve the efficiency of the imaging light field entering from the negative refraction structure into air, immersion liquid, and photoresist. The mechanism is to select a suitable material thickness and a suitable permittivity to reduce the difference between the effective refraction index of the negative refraction imaging structure and the effective refraction index of the outer space, so as to increase the transmission and output efficiency of the imaging light field.

A protective layer is further provided on the imaging output layers to protect the imaging output layers. It is required that a material of the protective layer is dense, chemically stable, and good in adhesion, which may effectively prevent oxidation and deliquescence of various materials in the negative refraction structure and the imaging output layers without affecting the imaging lithographic effect.

A protective pane is further provided on the protective layer to surround the protective layer, so that the negative refraction structure is spaced apart from the photoresist. The protective pane surrounds the pattern region and has a suitable height and a suitable width. The protective pane is used to prevent a pattern region of the lithographic lens from being damaged by contact during the lithographic processing. The protective pane has a height less than a working distance from a lower surface of the lithographic lens to an upper surface of the photoresist, has a suitable width, has a certain mechanical strength and good adhesion as a whole, and is easy to process. A composition material of the protective pane comprises, but not limited to, SiO₂, Si, etc.

A pattern of the lithographic plate mask is a pattern of lines arranged in the same direction, and an illumination light field which is in an electric field polarization state perpendicular to a direction of the lines is selected. The negative refraction imaging method and equipment may realize imaging with a 1:1 magnification, or achieve imaging with a reduced magnification by designing a curved negative refraction imaging structure. A reduction ratio may be 0.1-0.5 times.

Since the negative refraction imaging is a non-optical axis imaging method, it is easy to realize large-area high-resolution optical lithography. In practical cases, the imaging field is limited by control accuracy of a surface shape of the negative refraction imaging lithographic lens.

Fig. 5 illustrates a schematic diagram of a curved negative refraction imaging structure. As shown in Fig. 5, a mask 2, a negative refraction structure 3, photoresist 7, and an imaging device substrate 8 each have a curved surface. When an illumination light beam 1 is incident, a transmission light wave 6 passing through the mask 2 is transmitted in a negative refraction manner along a radial direction of the curved surface, and then is focused and imaged on the photoresist 7 to realize high-resolution imaging with a reduced magnification.

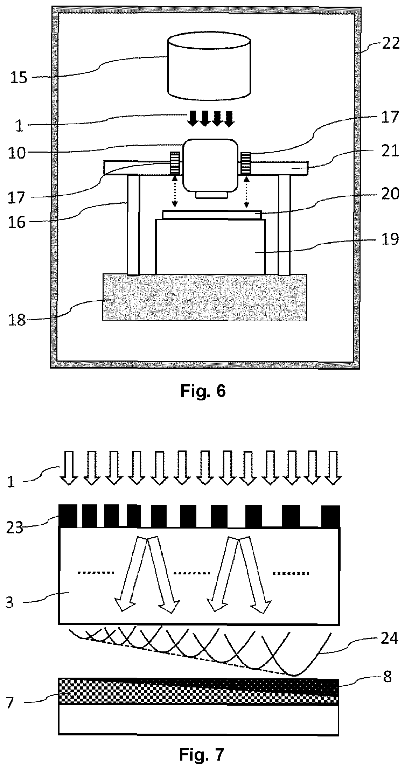

Fig. 6 illustrates a specific structural diagram of the negative refraction imaging lithographic equipment 200 shown in Fig. 2. As shown in Fig. 6, the negative refraction imaging lithographic equipment comprises an imaging lithographic lens 10, an exposure source 15, a substrate leveling and gap control system 16, a working distance detection system 17, a vibration isolation platform 18, a stage 19, an imaging substrate 20, an alignment and positioning system 21, and a clean box or vacuum box 22, etc.

Specifically, the negative refraction lithographic equipment may comprise a light source and illumination system, an imaging lithographic lens, a substrate leveling system, a working distance detection and control system, an alignment and positioning system, an air dust monitoring and purification system, etc. A wavelength of the illumination light source may cover deep ultraviolet to visible frequency bands, comprising, but not limited to, an i-line 365nm of a mercury lamp, g-lines 436nm, 248nm, 193nm, 157nm, etc.. The illumination system may adopt vertical illumination, off-axis illumination etc., or an arrayed light modulator may be introduced into the illumination system to achieve dynamic adjustment of parameters such as a direction, polarization, amplitude etc. of an illumination light beam. The adjustment methods used comprise, but not limited to, self-collimation leveling, three-point leveling, laser interference leveling, moire fringe leveling etc. The methods used by the working distance detection system comprise, but not limited to, a white light interference method, an interference spatial phase method, etc. The lithographic equipment may further comprise an air purification system, comprising, but not limited to, a vacuum cavity prepared for purifying and circulating air etc.

Fig. 7 illustrates a schematic diagram of grayscale lithography. For different step structures, grayscale masks 23 having fine structures with different f critical dimensions are designed and prepared. An illumination light beam 1 forms a non-uniform imaging light field 24 through the grayscale mask 23 and a negative refraction structure 3, and is used to expose photoresist 7 at different depths to obtain grayscale-sensitized photoresist 8 which is removed by development to realize processing of a stepped or even continuous surface shape.

The negative refraction structure has a binary structure pattern, a stepped and continuous surface shape structure pattern lithography capability, and a multilayered pattern structure overlay lithography capability. When negative refraction imaging lithographic processing is performed on a stepped and continuous surface shape structure pattern, a difference between pattern imaging intensities in regions with different step heights is generated due to a difference between negative refraction imaging optical transfer functions so as to obtain a multi-step pattern. A material of the photoresist layer comprises any of photoresist, a refraction index -modulation optically material, and an absorption modulation optically material. The photoresist used may be replaced with other photosensitive materials, comprising, but not limited to, a refraction index modulation optically material and an absorption modulation optically material. Micro-nano structures, for example, refraction index modulated optical waveguide gratings etc., in a form of non-geometric topography are realized by necessary post-processing.

A mask processing method for the negative refraction imaging lithography may be a stepping method or a scanning method. The negative refraction imaging lithographic method and equipment have a binary structure pattern, a stepped and continuous surface shape structure pattern lithography capability, and a multilayered pattern structure overlay lithography capability. A design of the pattern mask may be optimized to ensure that various parts of the pattern have substantially the same pattern imaging intensities. For different step structures, a design of fine structures of the mask with different critical dimensions may be optimized. A difference between pattern imaging intensities in regions with different step heights is generated due to a difference between negative refraction imaging optical transfer functions. Pattern structures of the photoresist at different heights are obtained after the photoresist is developed, and a multi-step pattern is further obtained by etching transfer. Continuous surface shape structure processing may be approximated and realized by increasing a number of steps. By using alignment marks of the negative refraction imaging lithographic lens, lithographic processing and etching transfer are performed on patterns of different layers many times, to ensure correct positions between the respective pattern layers, so as to realize multilayered pattern structure processing.

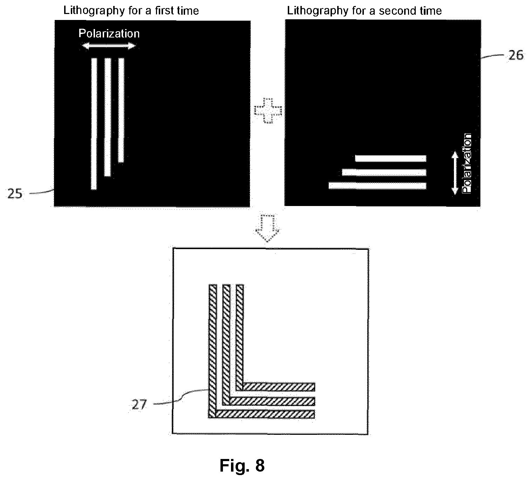

Fig. 8 illustrates a schematic diagram of two-dimensional pattern imaging lithography implemented by using the negative refraction imaging lithographic method and equipment according to an embodiment of the present disclosure. As shown in Fig. 8, a mask 25 is used for imaging lithography for a first time to obtain a vertical portion of a two-dimensional pattern 27, and then a mask 26 is used for imaging lithography for a second time to obtain a horizontal portion of the two-dimensional pattern 27. Stacking and developing may be performed after the imaging lithography is performed twice to obtain a high-resolution two-dimensional pattern 27.

Specific operations of the negative refraction imaging lithographic method and equipment according to the present disclosure will be described in detail below with reference to Figs. 1 to 6. Firstly, a Cr mask having a thickness of 60nm, a period of 700nm, and a duty ratio of 0.5 is prepared on a quartz substrate. A organic glass PMMA having a thickness of 50nm is spin-coated on the obtained Cr mask as a mask planarization layer. Eight Ag film layers and 7 TiO₂ film layers are alternately sputtered on the obtained structure, wherein each film layer has a thickness of 30nm, and a TiO₂ film having a thickness of 5nm continues to be sputtered on a surface of an outermost Ag film to prevent oxidation and deliquescence of the Ag film. A ultraviolet photoresist AR3170 having a thickness of 100nm is spin-coated on a surface of a quartz substrate. The above substrates are fixed on two stages of a precise gap control mechanism respectively, wherein quartz surfaces of the two substrates are in contact with the stages. The precise gap control mechanism - is controlled so that a gap between the two substrates is maintained to be about 400nm. TM polarized ultraviolet light having a central wavelength of 365nm and a light intensity of 1mW/m² is used for exposure from one side of the Cr mask for about 500s to cause the photoresist on the quartz substrate to be sensitized. The photoresist-coated quartz substrate is removed from the stages of the precise gap control mechanism. The obtained quartz substrate is placed into an AZ300 developer for development for about 10s to 15s, and the developed substrate is dried. A pattern of photoresist which is dense lines is obtained on the photoresist with a period of 700nm and a line width of 350nm.

Compared with conventional projection lithographic lens, dozens of lenses with a nano-precision in surface shape and position are not required in the negative refraction imaging lithographic method and equipment according to the embodiments of the present disclosure, which may be performed by integrated processing methods such as film deposition and electron beams etc., and thereby lens development costs may be drastically reduced. At the same time, the method has the characteristics of non-optical axis imaging, and the entire negative refraction imaging structure has spatial translational symmetry. In consideration of surface shape processing accuracy and an element size of planar elements at present, lithography with an imaging size of 100mm² or more of a field of view may be realized. Due to physical isolation between the substrate and the mask, this method may implement operations such as high-precision alignment, positioning, and overlay processing of multilayered nano-structures etc. Based on the negative-refraction imaging lithographic structure, the present disclosure may realize high-resolution grayscale lithography for processing of a multi-step or continuous surface shape.

Although the present disclosure has been particularly shown and described with reference to typical embodiments thereof, it will be understood by those of ordinary skill in the art that various changes may be made to these embodiments in form and detail without departing from the spirit and scope of the present disclosure as defined by the appended claims.

## Claims

1. A negative refraction imaging lithographic method, comprising:
coating photoresist on a device substrate;
fabricating a negative refraction structure, wherein the negative refraction structure exhibits a negative refraction index for a wavelength of light emitted by an exposure source;
pressing the lithographic plate mask to be close to the negative refraction structure;
disposing the lithographic plate mask and the negative refraction structure above the device substrate at a projection distance equal to a projection gap from the device substrate; and
emitting, by the exposure source, light, and sequentially projecting the light onto the photoresist for exposure through the lithographic plate mask, the negative refraction structure, and the projection gap.

2. The negative refraction imaging lithographic method according to claim 1, wherein the negative refraction index structure is equivalent to an anisotropic material, and a real part of a lateral component of a permittivity of the negative refraction index structure has an opposite sign to that of a real part of a longitudinal component of the permittivity, wherein for a composite structure composed of metal and a dielectric, an effective permittivity of the composite structure has a lateral component being *ε_{∥}=f*·*ε*_{d}+(1-*f*)·*ε*ₘ and a longitudinal component being *ε*_{⊥}=*ε*_{d}·*ε*ₘ /[f·*ε*ₘ+(1-*f*)·*ε*_{d}], wherein *ε_{∥}·ε*_{⊥}<0 so that the negative refraction index structure exhibits negative refraction characteristics, where *ε*_{d} and *ε*ₘ are permittivities of the dielectric and the metal in the composite structure respectively, *f* is a volume filling ratio of the metal.

3. The negative refraction imaging lithographic method according to claim 1, wherein an effective refraction index of the negative refraction structure is negative value, and the negative refraction structure comprises a multilayered negative refraction imaging lithographic structure, a hole-array multilayered negative refraction imaging lithographic structure, a composite negative refraction imaging lithographic structure, and a three-dimensional negative refraction structure.

4. The negative refraction imaging lithographic method according to claim 3, wherein a negative refraction structure of the multilayered negative refraction imaging lithographic structure is composed by alternately stacking two or more material film layers with different permittivities, and a thickness of the material film layers satisfies an effective condition of negative refraction imaging.

5. The negative refraction imaging lithographic method according to claim 1, wherein a real part of the permittivity of at least one kind of material in multilayers is negative.

6. The negative refraction imaging lithographic method according to claim 5, wherein a material of which a permittivity has a negative real part comprises gold, silver, and aluminum.

7. The negative refraction imaging lithographic method according to claim 3, wherein a two-dimensional hole array structure is introduced into the material of which a permittivity has a negative real part to modulate an effective permittivity and loss characteristics to realize negative refraction imaging, so as to form a hole-array multilayered negative refraction imaging lithographic structure.

8. The negative refraction imaging lithographic method according to claim 3, wherein the composite negative refraction imaging lithographic structure with a negative refraction index is obtained by designing a multilayer films and - hole-array -structure in combination.

9. The negative refraction imaging lithographic method according to claim 3, wherein the three-dimensional negative refraction structure is a three-dimensional metamaterial structure with a negative refraction index.

10. The negative refraction imaging lithographic method according to claim 1, wherein liquid is filled between the negative refraction imaging structure and the device substrate to be subjected to lithographic processing to increase an effective numerical aperture of the negative refraction imaging structure.

11. The negative refraction imaging lithographic method according to claim 1, wherein the negative refraction structure further comprises pattern input layers on opposite sides thereof, the pattern input layers planarize a pattern layer of the mask, and a composition material of the pattern input layers is a transparent material having a high refraction index and a low loss, and a thickness of the pattern input layer is optimized to be matched with parameters of the negative refraction structure.

12. The negative refraction imaging lithographic method according to claim 1, wherein the negative refraction structure further comprises imaging output layers on opposite sides thereof, and the imaging output layers are configured to reduce a difference between an effective refraction index of the negative refraction structure and an effective refraction index of an outer space where the projection gap is located.

13. The negative refraction imaging lithographic method according to claim 12, wherein a protective layer is further provided on the imaging output layers to protect the imaging output layers.

14. The negative refraction imaging lithographic method according to claim 13, wherein a protective pane is further provided on the protective layer to surround the protective layer, so that the negative refraction structure is spaced apart from the photoresist.

15. The negative refraction imaging lithographic method according to claim 1, wherein the pattern of the lithographic plate mask is composed of lines arranged in the same direction, and the electric field of the illumination light is polarized perpendicularly to the direction of the lines.

16. The negative refraction imaging lithographic method according to claim 1, wherein the negative refraction structure has a binary structure pattern, a stepped and continuous surface shape structure pattern lithography capability, and a multilayer pattern structure overlay lithography capability.

17. The negative refraction imaging lithographic method according to claim 16, wherein when negative refraction imaging lithographic processing is performed on a stepped and continuous surface shape structure pattern, a difference between pattern imaging intensities in regions with different step heights is generated due to a difference between negative refraction imaging optical transfer functions so as to obtain a multi-step pattern.

18. The negative refraction imaging lithographic method according to claim 1, wherein a material of the photoresist layer comprises any one of photoresist, a refraction index modulation optically material, and an absorbance modulation optically material.

19. A negative refraction imaging lithographic device, comprising:
an exposure source;
a photoresist coating apparatus configured to coat photoresist on a device substrate;
a negative refraction structure, wherein the negative refraction structure exhibits a negative refraction index for a wavelength of light emitted by an exposure source; and
a first transmission apparatus, configured to press a lithographic plate mask to be close to the negative refraction structure, and dispose the lithographic plate mask and the negative refraction structure above the device substrate at a projection distance equal to a projection gap away from the device substrate,
wherein light emitted by the exposure source passes through the lithographic plate mask, the negative refraction structure, the projection gap and is sequentially projected onto the photoresist for exposure.

20. The negative refraction imaging lithographic device according to claim 19, wherein the negative refraction index structure is equivalent to an anisotropic material, and a real part of a lateral component of a dielectric constant of the negative refraction index structure has an opposite sign to that of a real part of a longitudinal component of the dielectric constant, wherein for a composite structure composed of metal and a dielectric, an equivalent dielectric constant of the composite structure has a lateral component being *ε_{∥}*=*f·ε*_{d}+(1-*f*)·*ε*ₘ and a longitudinal component being *ε*_{⊥}=*ε*_{d}·*ε*ₘ/[*f*·*ε*ₘ+(1-*f*)·*ε*_{d}], wherein ε*_{∥}*·*ε*_{⊥}<0 so that the negative refraction index structure exhibits negative refraction characteristics, where *ε*_{d} and *ε*ₘ are dielectric constants of the dielectric material and the metal material in the composite structure respectively, and *f* is a volume filling ratio of the metal.

21. The negative refraction imaging lithographic device according to claim 19, wherein an equivalent refraction index of the negative refraction structure is a negative value, and the negative refraction structure comprises a multilayer film negative refraction imaging lithographic structure, a hole array multilayer negative refraction imaging lithographic structure, a composite negative refraction imaging lithographic structure, and a three-dimensional negative refraction structure.

22. The negative refraction imaging lithographic device according to claim 21, wherein a negative refraction structure of the multilayer film negative refraction imaging lithographic structure is formed by alternately stacking two or more material film layers having different dielectric constants, and a thickness of the material film layers satisfies an equivalent condition of negative refraction imaging.

23. The negative refraction imaging lithographic device according to claim 19, wherein a real part of a dielectric constant of at least one material of the material film layers is negative.

24. The negative refraction imaging lithographic device according to claim 21, wherein a two-dimensional hole array structure is introduced into the material of which a dielectric constant has a negative real part to modulate an equivalent dielectric constant and loss characteristics to realize negative refraction imaging, so as to form the hole array multilayer negative refraction imaging lithographic structure.

25. The negative refraction imaging lithographic device according to claim 21, wherein the composite negative refraction imaging lithographic structure having a negative refraction index is obtained by designing a multilayer film and a hole array layer structure in combination.

26. The negative refraction imaging lithographic device according to claim 21, wherein the three-dimensional negative refraction structure is a three-dimensional metamaterial structure having a negative refraction index.

27. The negative refraction imaging lithographic device according to claim 19, wherein liquid is filled between the negative refraction imaging structure and the device substrate to be subjected to lithographic processing to increase an equivalent numerical aperture of the negative refraction imaging structure.

28. The negative refraction imaging lithographic device according to claim 19, wherein the negative refraction structure further comprises pattern input layers on opposite sides thereof, the pattern input layers planarize a pattern layer of the mask, and a composition material of the pattern input layers is a transparent material having a high refraction index and a small loss, and a thickness of the pattern input layer is optimized to be matched with parameters of the negative refraction structure.

29. The negative refraction imaging lithographic device according to claim 19, wherein the negative refraction structure further comprises imaging output layers on opposite sides thereof, and the imaging output layers are configured to reduce a difference between an equivalent refraction index of the negative refraction structure and an equivalent refraction index of an outer space where the projection gap is located.

30. The negative refraction imaging lithographic device according to claim 29, wherein a protective layer is further provided on the imaging output layers to protect the imaging output layers.

31. The negative refraction imaging lithographic device according to claim 30, wherein a protective pane is further provided on the protective layer to surround the protective layer, so that the negative refraction structure is spaced apart from the photoresist.

32. The negative refraction imaging lithographic device according to claim 19, wherein a pattern of the lithographic plate is a pattern of lines arranged in the same direction, and an illumination light field which is in an electric field polarization state perpendicular to a direction of the lines.

33. The negative refraction imaging lithographic device according to claim 19, wherein the negative refraction structure has a binary structure pattern, a stepped and continuous surface shape structure pattern lithography capability, and a multilayer pattern structure overprint lithography capability.

34. The negative refraction imaging lithographic device according to claim 33, wherein when negative refraction imaging lithographic processing is performed on a stepped and continuous surface shape structure pattern, a difference between pattern imaging intensities in regions with different step heights is generated due to a difference between negative refraction imaging optical transfer functions so as to obtain a multi-step pattern.

35. The negative refraction imaging lithographic device according to claim 19, wherein a material of the photoresist layer comprises any one of photoresist, a refraction index light modulation material, and an absorbance light modulation material.
